## Europäisches Patentamt
## European Patent Office
## Office européen des brevets

(19)

(11) Veröffentlichungsnummer: **0 230 290 A2**

(12) # EUROPÄISCHE PATENTANMELDUNG

(21) Anmeldenummer: **87100572.4**

(51) Int. Cl.⁴: **H 01 J 27/00, H 01 J 37/00**

(22) Anmeldetag: **17.01.87**

(30) Priorität: **21.01.86 DE 3601632**

(43) Veröffentlichungstag der Anmeldung: **29.07.87** Patentblatt 87/31

(84) Benannte Vertragsstaaten: **CH DE FR GB IT LI NL**

(71) Anmelder: **Leybold-Heraeus GmbH, Bonner Strasse 498 Postfach 51 07 60, D-5000 Köln 51 (DE)**

(72) Erfinder: **Engemann, Jürgen, Prof. Dr., Fuhlrottstrasse 48, D-5600 Wuppertal 1 (DE)**

(74) Vertreter: **Zapfe, Hans, Dipl.-Ing., Seestrasse 2 Postfach 30 04 08, D-6054 Rodgau-3 (DE)**

(54) Verfahren zum Herstellen von Extraktionsgittern für Ionenquellen und durch das Verfahren hergestellte Extraktionsgitter.

(57) Verfahren zum Herstellen von Extraktionsgittern für Ionenquellen. Eine Trägerplatte (1) aus einem temperaturbeständigen Werkstofff wird beidseitig mit je einem durchgehenden Metallbelag (2, 3) versehen. In der Trägerplatte (1) und in den Metallbelägen (2, 3) wird ein im wesentlichen kongruentes Lochmuster erzeugt. Bei einem derartigen Extraktionssystem bilden die beidseitigen, elektrisch voneinander getrennten Metallbeläge Extraktionsgitter bzw. Elektroden. Durch Anordnung eines Kernbereichs (1a) aus einem leitenden oder halbleitenden Werkstoff in der Trägerplatte (1) lässt sich eine dritte Elektrode zur Steuerung des Ionenstrahls erzeugen.

EP 0 230 290 A2

ACTORUM AG

LEYBOLD-HERAEUS  G m b H
Bonner Straße 498

D-5000 Köln - 51

---------------------------------------------------------------

" Verfahren zum Herstellen von Extraktionsgittern für Ionenquellen und durch das Verfahren hergestellte Extraktionsgitter "

---------------------------------------------------------------

Die Erfindung betrifft ein Verfahren zum Herstellen von Extraktionsgittern für Ionenquellen.

Eine derartige Ionenquelle mit Extraktionsgittern sowie Sinn und Zweck derartiger Extraktionsgitter sind durch die US-PS 4 507 588 bekannt. Wesentlicher Teil der Ionenquelle ist eine Kammer, in der ein Plasma erzeugt wird und die eine Öffnung aufweist, in der eine Reihenschaltung von mindestens zwei Extraktionsgittern angeordnet ist, durch die das Plasma aus der genannten Kammer herausgezogen und in Richtung auf einen zu bearbeitenden Körper, das sogenannte Substrat, beschleunigt wird. Bei der

- 2 -

bekannten Lösung bestehen die Extraktionsgitter aus rasterförmig perforierten Blechen durch deren Löcher einzelne
Ionenstrahlen gerichtet hindurchtreten. Diese perforierten
Bleche bringen einige·Probleme mit sich,
worauf nachfolgend noch näher eingegangen wird.

Im Bereich der Mikrostrukturtechnik sind für die
Abscheidung hochqualitativer dünner Schichten aus
metallischen und nicht-metallischen Werkstoffen sowie
für die Strukturierung im unteren Mikrometerbereich
leistungsfähige Ionenquellen mit großflächigen
Extraktionsgittern erforderlich, die auch als "Multiapertur-
Optiken" bezeichnet werden. Die größten heute in
technischem Maßstab eingesetzten Ionenquellen beruhen
auf dem Kaufman-Prinzip, d.h. mittels Gleichspannung
werden Elektronen durch Emitter (z.B. Filamente, Hohlkatoden)
in die Plasmakammer eingeführt. Derartige Ionenquellen ermöglichen maximale Stromdichten von etwa 4 mA/cm²
bei maximalen Strahldurchmessern von etwa 16 cm. Die
Ionen-Energien sind dabei von 150 bis 2000 eV einstellbar.

Die Extraktion von Ionen aus dem Plasma und die Strahlführung werden im wesentlichen durch die verwendete
Etraktionsoptik bestimmt, die durch Zwei- oder Mehrgittersysteme oder auch nur ein Gitter gebildet werden kann. Hierbei
kommt es auf folgende Kriterien besonders an:

1. Die Extraktionsoptiken müssen im Interesse höherer
   Strahlstromdichten temperaturbeständig sein, und
   zwar im Hinblick auf einen Verzug der einzelnen Optiken
   und im Hinblick auf eine Dejustierung der einzelnen Gitter gegeneinander. Die Maximaltemperatur der Gitter liegt aufgrund der heute verfügbaren Werkstoffe bei etwa 200 °C.

2. Die Gesamtfläche des Extraktionsgitters soll skalierbar sein, wobei das Überschreiten des oben angegebenen Strahldurchmessers von 16 cm auf Schwierigkeiten durch die maximale Temperaturbelastbarkeit der Gitter stößt.

3. Der Abstand der Gitter untereinander soll bestimmten Bedingungen genügen, wobei dieser Abstand die maximal extrahierbare Ionenstromdichte J festlegt: Es gilt die Proportionalität:

$$J = \frac{U^{3/2}}{d^2}$$

wobei U die Extraktionsspannung zwischen den Gittern und d der Abstand der Gitter voneinander ist. Auch wirken wiederum thermische Effekte einschränkend auf die Verringerung des Abstandes ein. Es war bis heute nicht möglich, den Gitterabstand unter 1 mm zu senken.

Ein kleiner Gitterabstand d mit einem Aspektverhältnis (=mittlerer Durchmesser einer Gitteröffnung: Gitterabstand) von 1 liegt auch im Interesse von kleinen Extraktionsspannungen, d.h. geringen Ionenenergien beim sogenannten Ionenstrahlätzen, bei dem parallele Ionenstrahlen mit Energien wesentlich unterhalb von 1 ke V gebildet werden.

Bei Beschichtungsvorgängen, der sogenannten Strahldeposition, ändern sich die Verhältnisse wie folgt: Zwar sollte auch hier das Aspektverhältnis bei etwa 1 liegen; der Gitterabstand sollte jedoch wegen höherer Strahlspannungen problemlos vergrößerbar sein, da dies einen Einfluß auf die Durchschlagfestigkeit, die Ionen-Energien und die Sputter-Ausbeute hat.

4. Die Dicke der Extraktionsgitter wird gleichfalls durch die thermische Belastung bestimmt. Insbesondere das dem Plasma am nächsten liegende Gitter ist hohen thermischen Belastungen ausgesetzt. Um einem Verzug der Einzeloptiken bzw. einer Dejustierung der einzelnen Gitter entgegenwirken zu können, war es bisher nicht möglich, den Wert von 1 mm für die Dicke des Gitters bei der oben angegebenen Ionenquelle mit einem Strahldurchmesser von 16 cm wesentlich zu unterschreiten. Die Forderung nach einer hinreichenden Wärmeableitung steht der Forderung nach einer extrem geringen Gitterdichte diametral entgegen, da dünne Gitter sowohl die Aberrationen verringern als auch die extrahierbaren Ionenstromdichten erhöhen.

5. Aus Gründen der mechanischen Stabilität und der Temperaturbelastbarkeit ist die Materialauswahl für die Extraktionsgitter begrenzt. Bei den bisher bekannten Ionenquellen werden überwiegend Molybdän, Wolfram und Graphit als Gitterwerkstoffe verwendet. Mit Argon als Arbeitsgas sind bei einer vorgegebenen Beschleunigungsspannung möglichst geringe Ausbeuten Y (Yields) anzustreben, um eine unerwünschte Kontamination der zu beschichtenden Substrate zu minimieren. Bei senkrechtem Ioneneinfall und einer Energie von 1 keV sind folgende Werte typisch:

$$\text{Molybdän (Mo)} : Y = 1,3$$
$$\text{Wolfram} \quad (W) : Y = 0,8$$
$$\text{Graphit} \quad (C) : Y = 0,6.$$

Danach sind Graphit und Wolfram, sowie in eingeschränktem Maß Molybdän, durchaus günstige Werkstoffe.

Die Situation verschlechtert sich, wenn im Interesse erhöhter Selektivitäten mit reaktiven Gasen gearbeitet wird. $CF_4$ wird häufig als Arbeitsgas in der Halbleitertechnologie eingesetzt. Dieses Gas greift sowohl Molybdän als auch Wolfram an. Werden Beimischungen von Sauerstoff verwendet, so ist auch Graphit als Elektrodenmaterial problematisch.

Der Erfindung liegt daher die Aufgabe zugrunde, ein Herstellverfahren für Extraktionsgitter anzugeben, die in hohem Maße temperaturbeständig sind, höhere spezifische Extraktionsströme und größere Strahlquerschnitte ermöglichen.

Die Lösung der gestellten Aufgabe erfolgt erfindungsgemäß dadurch, daß man eine Trägerplatte aus einem temperaturbeständigen Werkstoff beidseitig mit je einem durchgehenden Metallbelag versieht und in der Trägerplatte und in den Metallbelägen ein im wesentlichen kongruentes Lochmuster erzeugt.

Die Trägerplatte kann dabei aus einem mineralischen Isolierstoff, wie Glas, Keramik oder Glaskeramik bestehen. Das Lochmuster kann sowohl vor als auch nach dem Aufbringen der Metallbeläge erzeugt werden. So ist es beispielsweise möglich, die Trägerplatte beidseitig mit geschlossenen Metallbelägen zu versehen, und in dieser Sandwich-Struktur durch einen Ätzvorgang ein kongruentes Lochmuster zu erzeugen. Die Erfindung ermöglicht eine große Flexibilität in der Auswahl des Materials.

Es ist jedoch gemäß einer weiteren Ausgestaltung der Erfindung besonders vorteilhaft, wenn man zunächst die Trägerplatte unter Stehenlassen von Stegen mit einem Lochmuster versieht und nachfolgend die Stege unter Offenhaltung der Löcher beidseitig mit den durchgehenden Metallbelägen versieht. Der Ausdruck "durchgehende Metallbeläge" besagt, daß diese - mit Ausnahme des Lochmusters - nicht unterbrochen sind, so daß sie als Elektroden dienen können. Das Lochmuster dient alsdann zum Durchtritt der einzelnen Ionenstrahlen, die gemeinsam einen Ionenstrahl mit großer Querschnittsfläche bilden.

Mit einer derartigen Extraktionsoptik ist eine Reihe von Vorteilen verbunden: Zunächst entfällt das Justieren der einzelnen Gitter zueinander. Eine Verschiebung der beiden Extraktionsgitter gegeneinander ist ausgeschlossen, so daß die fluchtende Anordnung der Lochmuster in den beiderseitigen Metallbelägen auch bei hoher thermischer Belastung erhalten bleibt. Ferner legt die verhältnismäßig gering zu wählende Dicke der Trägerplatte den Abstand der beiden Extraktionsgitter unveränderbar fest. Auch durch hohe thermische Belastung der Extraktionsoptik kann sich dieser Abstand nicht ändern. Die mechanische Belastung der Extraktionsgitter ist gering, da sie nicht selbst tragend sind, sondern durch die Trägerplatte unterstützt werden. Dünne Metallbeläge in der Größenordnung von 0,1 mm sind bei einer Dicke der Trägerplatte von 0,2 bis 0,4 mm durchaus realisierbar, d.h. der weiter oben angegebene Abstand d beläuft sich auf eben diese 0,2 bis 0,4 mm.. Dadurch läßt sich die maximale Ionenstromdichte entsprechend steigern. Weiterhin ist die Herstellung großflächiger Extraktionsoptiken für Strahldurchmesser oberhalb von 16 cm möglich, und die Extraktionsoptik ist auch nach längerem Betrieb durch erneutes Metallisieren regenerierbar. Vor allem aber kann die Ionenstromdichte gegenüber dem Stande der Technik erheblich gesteigert werden, wobei Maximaltemperaturen der Extraktionsoptik von etwa 550 °C durchaus möglich sind.

Als Material für die Trägerplatte kann bevorzugt ein ganz oder teilweise fotoempfindlicher Werkstoff verwendet werden, den man nach Maßgabe des Lochmusters belichtet und nachfolgend das Lochmuster durch einen Ätzvorgang erzeugt. Ein gut geeigneter Werkstoff für die Trägerplatte ist ein von der Firma Schott Glaswerke in Mainz/BRD unter der Bezeichnung "Foturan" vertriebener Werkstoff, der nach Bestrahlung mit UV-Licht durch eine Maske und anschliessende Wärmebehandlung örtlich in eine kristallisierte bzw. ätzbare Phase umgewandelt wird, die durch einen sich anschliessenden Ätzprozeß aus dem übrigen Werkstoff herausgelöst wird. Das betreffende Material hat ein ausgesprochen anisotrophes Ätzverhalten, so daß das erzeugte Lochmuster von nahezu senkrecht zur Trägerplatte verlaufenden Seitenwänden begrenzt wird.

Auf eine derart hergestellte Trägerplatte mit Lochmuster können die beidseitigen Metallbeläge durch ein herkömmliches Beschichtungsverfahren wie Platieren oder Galvanisieren aufgebracht werden. Besonders vorteilhaft ist jedoch ein physikalisches Vakuumverfahren wie das Aufdampfverfahren oder Katodenzerstäubungsverfahren. Mit derartigen Verfahren läßt sich eine sehr gezielte Beschichtung herstellen, indem eine Maske verwendet wird.

Sofern man die beidseitigen Metallbeläge auf eine bereits mit einem Lochmuster versehene Trägerplatte aufbringt, empfiehlt es sich, die Löcher mit einem leicht herauslösbaren Material vorübergehend zu verschliessen, um Brückenbildungen zwischen den beidseitigen Metallbelägen zu verhindern.

Da die Vakuumbeschichtung ein verhältnismäßig langsam ablaufender Vorgang ist, können derart aufgebrachte Metallbeschichtungen nachträglich durch leistungsfähigere Verfahren, wie'beispielsweise durch galvanische Prozesse, verstärkt werden. Die Wahl des metallischen Werkstoffes für die Extraktionsgitter ist weitgehend frei und orientiert sich nur an den Bedürfnissen des jeweiligen technologischen Einsatzes der Ionenquelle.

Bei der Herstellung der Metallbeläge durch ein Vakuumverfahren empfiehlt es sich, zwischen der Trägerplatte und dem jeweiligen Metallbelag noch eine dünne Schicht aus einem Haftvermittler wie beispielsweise aus Chrom aufzubringen.

Es ist schließlich auch und mit besonderem Vorteil möglich, als Trägerplatte einen Halbleiterwerkstoff mit anisotropem Ätzverhalten zu verwenden und auf diesen

- 10 -

zunächst beidseitig je eine Schicht aus einem Isoliermaterial aufzubringen, auf die man schließlich je einen Metallbelag aufbringt. Als Halbleiterwerkstoff mit anisotropem Ätzverhalten kann z.B. "110-Si" verwendet werden. Die Schichten aus Isoliermaterial können bevorzugt aus $SiO_2$, $Si_3N_4$ hergestellt werden, und zwar durch thermische Verdampfung, einen chemischen Beschichtungsprozeß (CVD), durch ein Plasmaverfahren oder durch Katodenzerstäubung. Die Herstellung der beidseitigen Metallbeläge ist auf die weiter oben angegebene Art möglich.

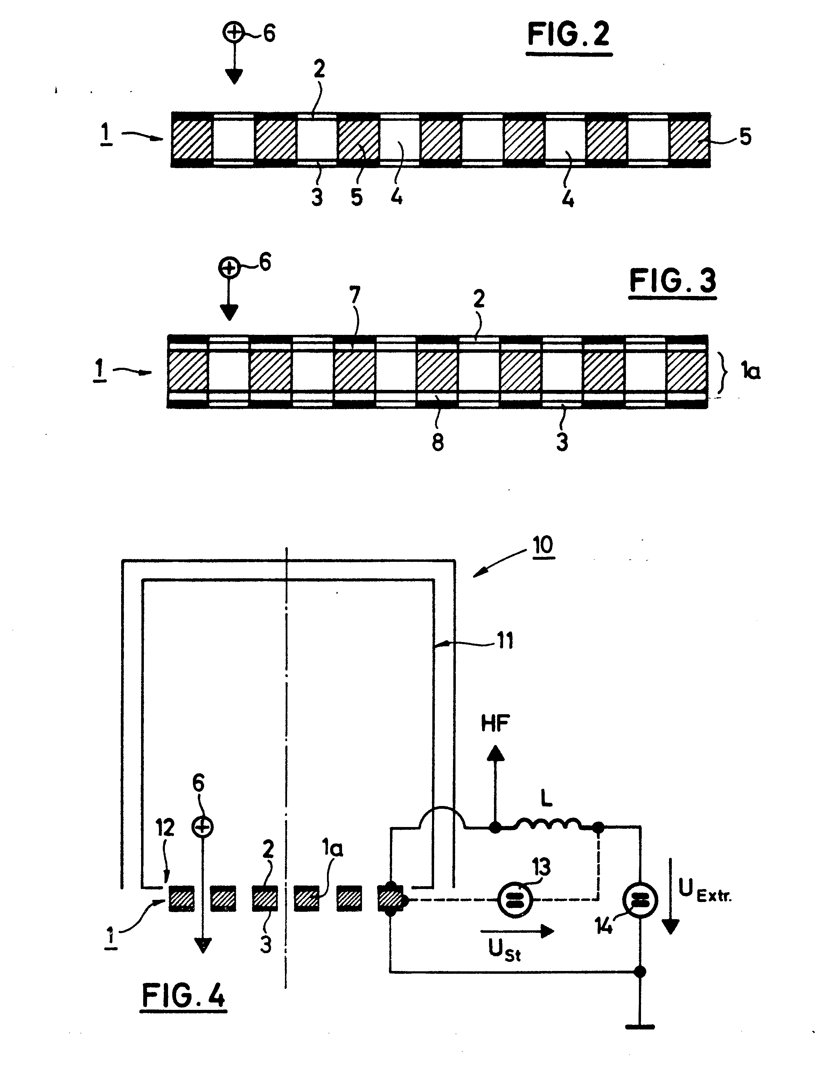

Der metallische oder Halbleiterwerkstoff, der den Kernbereich der Trägerplatte einnimmt, kann gleichzeitig als elektrisch vorgespannte Steuerelektrode zur elektrostatischen Manipulation des Strahlprofils verwendet werden, was anhand der Figur 4 noch näher erläutert werden wird.

Der Kernbereich kann dabei auch als dritte Elektrode bezeichnet werden. Umfaßt die Extraktionsoptik mehr als drei Gitter, so werden mehrere Trägerplatten erforderlich, von denen jede wiederum zwei (oder drei) Gitter aufnehmen kann. Die Technologie der Herstellung bleibt unverändert, allerdings wird zusätzlich eine Justiermaßnahme der beiden Trägerplatten mit Metallbelägen gegeneinander erforderlich. Stehen jedoch Ionenquellen mit ausreichender Strahlstromdichte auch bei Extraktionsspannungen unterhalb von einem kV zur Verfügung (sogenannte ECR-Mikrowellen-Ionenquellen), so reichen in der Regel zwei Extraktionsgitter, d.h. eine Trägerplatte aus.

Weitere vorteilhafte Ausgestaltungen des Erfindungsgegenstandes ergeben sich aus den übrigen Unteransprüchen.

Die Erfindung bezieht sich auch auf ein Extraktionsgitter für Ionenquellen, das erfindungsgemäß gekennzeichnet ist durch eine Trägerplatte aus einem temperaturbeständigen Werkstoff mit beidseitigen, durchgehenden, aber elektrisch voneinander getrennten Metallbelägen und durch ein durch die Metallbeläge und die Trägerplatte hindurchgehendes im wesentlichen kongruentes Lochmuster.

Ein solches Extraktionsgitter kann bevorzugt dadurch eine dritte Elektrode enthalten, wenn nämlich die Trägerplatte einen Kernbereich aus einem metallischen oder Halbleiterwerkstoff, zwei beidseitig angrenzende Isolierstoffschichten und zwei darüberliegenden Metallschichten aufweist.

Ausführungsbeispiele des Erfindungsgegenstandes werden nachfolgend anhand der Figuren 1 bis 4 näher erläutert.

Es zeigen:

Figur 1      eine Draufsicht auf eine der beiden plan-
             parallelen Oberflächen einer Extraktions-
             optik,

Figur 2      einen Schnitt durch eine Extraktionsoptik
             mit zwei durch zwei Metallbeläge gebildeten
             Elektroden,

Figur 3      einen Schnitt durch eine Extraktionsoptik
             mit drei durch zwei Metallbeläge und einen
             Kernbereich aus einem metallischen oder Halbleiterwerkstoff gebildeten Elektroden und

Figur 4      die Anordnung einer Extraktionsoptik nach
             Figur 3 im Zusammenwirken mit einer Ionenquelle.

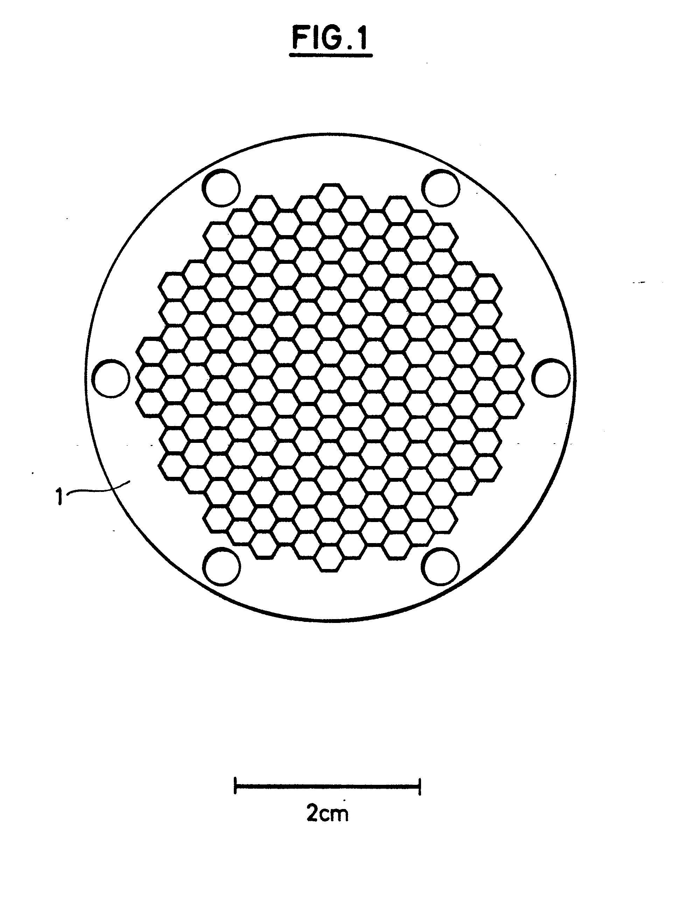

In Figur 1 ist eine Trägerplatte 1 aus einem
temperaturbeständigen, mineralischen Isolierstoff
dargestellt, die noch nicht mit den metallischen
Belägen versehen ist, jedoch bereits das weiter
oben beschriebene Lochmuster enthält, bei dem sich
zwischen den einzelnen Löchern Stege befinden, die
auf den Kanten je eines Sechsecks verlaufen, so daß
das Lochmuster durch eine Art Bienenwabenstruktur
gebildet und begrenzt wird. Am Rande der Trägerplatte
befinden sich sechs größere Bohrungen für Schrauben,
mit denen die Trägerplatte in fertigem Zustand mit einer Ionenquelle verbunden werden kann.

Figur 2 zeigt einen vergrößerten Querschnitt durch den Gegenstand nach Figur 1. In diesem Fall ist die Trägerplatte 1 auf beiden Seiten mit je einem Metallbelag 2 und 3 versehen, wobei in der Trägerplatte 1 und in den Metallbelägen 2 und 3 ein kongruentes Lochmuster vorhanden ist, das aus einzelnen Löchern 4 besteht. Mit anderen Worten: Die Metallbeläge 2 und 3 bilden nur im Bereich der Stege 5 je einen zusammenhängenden Belag.

Der obere Metallbelag 2 befindet sich auf der sogenannten Plasmaseite, während sich der untere Metallbelag 3 auf der sogenannten Substratseite befindet. Die Plasmaseite wird durch ein Ion 6 angedeutet.

Bei dem Ausführungsbeispiel gemäß Figur 3 besteht die Trägerplatte 1 aus einem Halbleiterwerkstoff, der in Übereinstimmung mit Figur 2 mit einem analogen Lochmuster versehen ist. Die Trägerplatte bildet jedoch einen sogenannten Kernbereich 1a, der aus dem Halbleiterwerkstoff besteht und eine dritte Elektrode bildet. Dieser Kernbereich weist auf beiden planparallelen Begrenzungsflächen je eine Isolierstoffschicht 7 bzw. 8 auf, und diese sind wiederum mit je einem darüberliegenden Metallbelag 2 und 3 analog Figur 2 versehen.

Es ist zu erkennen, daß auch hier der Kernbereich 1a, die Isolierstoffschichten 7 und 8 und die Metallbeläge 2 und 3 mit einem kongruenten Lochmuster versehen sind, so daß Ionen 6 durch die betreffenden Löcher 4 hindurchtreten können.

Den Einbau eines Extraktionsgitters nach Figur 3 in eine Ionenquelle 10 zeigt Figur 4. Zur Ionenquelle 10 gehört eine Kammer 11, der eine nicht näher dargestellte Einrichtung zur Erzeugung und Aufrechterhaltung eines Plasmas zugeordnet ist, das aus Ionen 6 besteht. Diese Kammer 11 besitzt an ihrer Unterseite eine Öffnung 12, die durch das Extraktionsgitter mit der Trägerplatte 1 nach Figur 3 verschlossen ist. Die Metallbeläge 2 und 3 werden in herkömmlicher Weise so geschaltet, daß der dem Plasma zugewandte Metallbelag 2, der das eine Extraktionsgitter bzw. die eine Elektrode bildet, auf positivem Potential und der Metallbelag 3, der das andere Extraktionsgitter bzw. die andere Elektrode bildet, auf Massepotential liegt. Diese Anordnung sichert weitgehend die Feldfreiheit im Arbeitsraum, d.h. in dem der Elektrode 3 zugewandten Bereich. Bei variabler positiver Vorspannung des aus Halbleitermaterial bestehenden Kernbereichs 1a eröffnet sich zusätzlich die Möglichkeit, die Strahlcharakteristik nach Maßgabe der Steuerspannung $U_{st}$ zu manipulieren, und zwar zur Beeinflussung der Strahlcharakteristik (Emittanz) und zum Zwecke einer Homogenisierung des Ionenstrahls. Zu diesem Zweck ist der

aus Halbleitermaterial bestehende Kernbereich 1a an eine Spannungsquelle 13 gelegt, in der die variable Steuerspannung $U_{st}$ erzeugt wird. Die sogenannte Extraktionsspannung $U_{Extr}$ wird durch eine weitere Spannungsquelle 14 erzeugt, die an die Metallbeläge 2 und 3 gelegt ist. Eine Hochfrequenzquelle HF, die nur sehr schematisch angedeutet ist, dient zur Erregung des Plasmas in der Kammer 11.

Durch die dargestellten Schaltungsmaßnahmen läßt sich die Wechselwirkung der zu ektrahierenden Ionen mit der Trägerplatte reduzieren, so daß deren thermische Belastung gering gehalten und parasitäres Sputtern an diesen Stellen reduziert wird.

ANSPRÜCHE:

1. Verfahren zum Herstellen von Extraktionsgittern
   für Ionenquellen, dadurch gekennzeichnet, daß
   man eine Trägerplatte aus einem temperaturbeständigen Werkstoff beidseitig mit je einem
   durchgehenden Metallbelag versieht und in der
   Trägerplatte und den Metallbelägen ein im
   wesentlichen kongruentes Lochmuster erzeugt.

2. Verfahren nach Anspruch 1, dadurch gekennzeichnet,
   daß man die Trägerplatte unter Stehenlassen von
   Stegen mit einem Lochmuster versieht und nachfolgend die Stege unter Offenhaltung der Löcher
   beidseitig mit den durchgehenden Metallbelägen
   versieht.

3. Verfahren nach Anspruch 2, dadurch gekennzeichnet,
   daß man eine Trägerplatte aus einem ganz oder teilweise fotoempfindlichen Werkstoff verwendet, diesen
   nach Maßgabe des Lochmusters belichtet und die
   Löcher durch einen Ätzvorgang erzeugt.

4. Verfahren nach Anspruch 3, dadurch gekennzeichnet,
   daß man die Trägerplatte aus einem mineralischen
   Werkstoff mit anisotropem Ätzverhalten herstellt.

5. Verfahren nach Anspruch 4, dadurch gekennzeichnet, daß man als Werkstoff ein lichtempfindliches Glas verwendet.

6. Verfahren nach Anspruch 1, dadurch gekennzeichnet, daß man die beidseitigen Metallbeläge durch ein Vakuumverfahren aufbringt.

7. Verfahren nach Anspruch 6, dadurch gekennzeichnet, daß man bei der Vakuumbeschichtung eine Maske verwendet.

8. Verfahren nach Anspruch 7, dadurch gekennzeichnet, daß man die Metallbeläge im Anschluß an die Vakuumbeschichtung durch ein Verfahren mit höherer Niederschlagsrate verstärkt.

9. Verfahren nach Anspruch 1, dadurch gekennzeichnet, daß man als Trägerplatte einen Halbleiterwerkstoff mit anisotropem Ätzverhalten verwendet, auf diesen zunächst beidseitig je eine Schicht aus einem Isoliermaterial aufbringt und schließlich auf jede Isolierstoffschicht einen Metallbelag aufbringt.

10. Verfahren nach Anspruch 9, dadurch gekennzeichnet, daß man die Metallbeläge selektiv durch einen Maskierungsvorgang aufbringt und sie bei einem nachfolgenden Ätzvorgang als Ätzmasken verwendet.

11. Extraktionsgitter für Ionenquellen, <u>gekennzeichnet durch</u> eine Trägerplatte (1) aus einem temperaturbeständigen Werkstoff mit beidseitigen, durchgehenden, aber elektrisch voneinander getrennten Metallbelägen (2, 3) und durch ein durch die Metallbeläge und die Trägerplatte hindurchgehendes, im wesentlichen kongruentes Lochmuster (4).

12. Extraktionsgitter nach Anspruch 11, <u>dadurch gekennzeichnet</u>, daß die Trägerplatte (1) einen Kernbereich (1a) aus einem metallisch leitenden oder halbleitenden Werkstoff, zwei beidseitig angrenzende Isolierstoffschichten (7, 8) und zwei darüberliegende Metallbeläge (2, 3) aufweist.

## FIG.1

1

|———————| 2cm

**FIG.2**

**FIG.3**

HF

L

$U_{Extr.}$

$U_{St}$

**FIG.4**